# EUROPEAN PATENT APPLICATION

(11) **EP 4 769 489 A1**
(43) Date of publication of application: **01.07.2026**
(21) Application number: 25800322.7
(22) Date of filing: 05.03.2025
(51) Int. Cl.: H01L 23/488, H01L 21/60

(54) **HYBRID BONDING STRUCTURE, MANUFACTURING METHOD THEREFOR, AND SEMICONDUCTOR DEVICE**

(30) Priority: 21.10.2024 CN 202411472724
(71) Applicant: CXMT Corporation, Hefei, Anhui 230601 (CN)
(72) Inventor: FANG, Qingchun, Hefei, Anhui 230601 (CN)
(74) Representative: Gulde & Partner
(86) International application number: PCT/CN2025/080723
(87) International publication number: WO 2026/086076

(57) **Abstract**

Disclosed are a hybrid bonding structure, a manufacturing method therefor, and a semiconductor device. The hybrid bonding structure includes: a dielectric layer, including a first dielectric layer and a second dielectric layer that are configured in a bonded manner; a bonding interface layer, located between the first dielectric layer and the second dielectric layer; a metal structure, located in the dielectric layer; and a diffusion barrier layer, located in the dielectric layer, where the diffusion barrier layer separates the bonding interface layer. The hybrid bonding structure can improve device performance.

## Description

This application claims priority to Chinese Patent Application No. 202411472724.6, filed with China National Intellectual Property Administration on October 21, 2024, and entitled "HYBRID BONDING STRUCTURE, MANUFACTURING METHOD THEREFOR, AND SEMICONDUCTOR DEVICE". The above-referenced application is incorporated herein by reference in its entirety.

### TECHNICAL FIELD

Embodiments of the present disclosure relate to the technical field of semiconductors, and in particular to a hybrid bonding structure, a manufacturing method therefor, and a semiconductor device.

### BACKGROUND

A wafer bonding technology is one of the key technologies for implementing a three-dimensional integrated circuit. Among them, the hybrid bonding technology can implement internal connections of thousands of chips, significantly improving chip performance, saving area, and reducing costs.

However, a hybrid bonding method brings a risk of metal diffusion.

### SUMMARY

According to a first aspect of the embodiments of the present disclosure, a hybrid bonding structure is provided. The hybrid bonding structure includes:
a dielectric layer, including a first dielectric layer and a second dielectric layer that are configured in a bonded manner;
a bonding interface layer, located between the first dielectric layer and the second dielectric layer;
a metal structure, located in the dielectric layer; and
a diffusion barrier layer, located in the dielectric layer, where the diffusion barrier layer separates the bonding interface layer.

In some embodiments, the diffusion barrier layer surrounds the metal structure.

In some embodiments, a thickness of the bonding interface layer is less than a thickness of the diffusion barrier layer.

In some embodiments, the metal structure includes a first metal structure and a second metal structure, the diffusion barrier layer is located between the first metal structure and the second metal structure, and a spacing from the diffusion barrier layer to the first metal structure is different from a spacing from the diffusion barrier layer to the second metal structure.

In some embodiments, the diffusion barrier layer includes a first diffusion barrier layer and a second diffusion barrier layer, the first diffusion barrier layer surrounding the first metal structure, and the second diffusion barrier layer surrounding the second metal structure.

A spacing from the first diffusion barrier layer to the second diffusion barrier layer is greater than a spacing from the first diffusion barrier layer to the first metal structure.

In some embodiments, the first diffusion barrier layer includes:
a lower barrier layer; and
an upper barrier layer, located on the lower barrier layer.

The upper barrier layer and the lower barrier layer do not undergo a bonding reaction.

In some embodiments, an orthographic projection region of the lower barrier layer is located within an orthographic projection region of the upper barrier layer.

In some embodiments, the lower barrier layer of the first diffusion barrier layer is located in the first dielectric layer, and the upper barrier layer of the first diffusion barrier layer is located in the second dielectric layer; the lower barrier layer of the second diffusion barrier layer is located in the second dielectric layer, and the upper barrier layer of the second diffusion barrier layer is located in the first dielectric layer.

In some embodiments, the lower barrier layer includes one of a metal barrier layer or an insulating barrier layer, and the upper barrier layer is the other of the metal barrier layer or the insulating barrier layer.

In some embodiments, a thickness of the upper barrier layer is greater than a thickness of the lower barrier layer.

In some embodiments, a top surface of the upper barrier layer is in contact with the lower barrier layer, and a nitrogen concentration at a bottom of the upper barrier layer is less than a nitrogen concentration at a top of the upper barrier layer.

In some embodiments, a plurality of the metal structures are provided, and the plurality of metal structures share a same diffusion barrier layer.

In some embodiments, a plurality of the metal structures are provided, and a plurality of the diffusion barrier layers are provided, a number of the metal structures being equal to a number of the diffusion barrier layers.

In some embodiments, each of the diffusion barrier layers surrounds each of the metal structures, and the plurality of diffusion barrier layers are independent of each other.

In some embodiments, the metal barrier material includes tantalum or tantalum nitride, and the insulating barrier material includes silicon nitride or silicon carbonitride.

According to a second aspect of the embodiments of the present disclosure, a method for manufacturing a hybrid bonding structure is provided. The method includes:

providing a first dielectric layer, where the first dielectric layer includes a lower metal structure and a lower barrier layer;

providing a second dielectric layer, where the second dielectric layer includes an upper metal structure and an upper barrier layer; and

bonding the first dielectric layer and the second dielectric layer, and bonding the upper metal structure and the lower metal structure, to form a dielectric layer and a metal structure, respectively.

During the bonding, a bonding interface layer is formed between the first dielectric layer and the second dielectric layer; the upper barrier layer is in contact with the lower barrier layer to form a diffusion barrier layer, and the diffusion barrier layer separates the bonding interface layer.

In some embodiments, during the bonding, the upper barrier layer and the lower barrier layer do not undergo a bonding reaction.

In some embodiments, a step of forming the lower barrier layer includes:
forming, in the first dielectric layer, a trench surrounding the lower metal structure; and
filling the trench with a diffusion barrier material to form the lower barrier layer.

In some embodiments, a step of forming the upper barrier layer includes:
forming, in the second dielectric layer, a trench surrounding the upper metal structure; and
filling the trench with a diffusion barrier material to form the upper barrier layer.

A nitrogen concentration at a top of the upper barrier layer is greater than a nitrogen concentration at a bottom of the upper barrier layer.

According to a third aspect of the embodiments of the present disclosure, a semiconductor device is provided. The semiconductor device includes the hybrid bonding structure described above.

In summary, the embodiments of the present disclosure propose a hybrid bonding structure, a manufacturing method therefor, and a semiconductor device. A dielectric layer of the hybrid bonding structure includes a diffusion barrier layer, and the diffusion barrier layer separates a bonding interface layer. When metal atoms diffuse in the bonding interface layer, the diffusion barrier layer can block the metal atoms from further diffusing along the bonding interface layer, reducing the risk posed by the diffusion of metal atoms.

### BRIEF DESCRIPTION OF DRAWINGS

FIG. 1 is a schematic view of a hybrid bonding structure according to an exemplary embodiment;
FIG. 2 is an enlarged schematic view of a dashed box in FIG. 1 according to an exemplary embodiment;
FIG. 3 is a brief top view of the hybrid bonding structure in FIG. 1 according to an exemplary embodiment;
FIG. 4 is a schematic view of a plurality of metal structures according to an exemplary embodiment;
FIG. 5 is a brief top view of the hybrid bonding structure in FIG. 4 according to an exemplary embodiment;
FIG. 6 is another schematic view of a plurality of metal structures according to an exemplary embodiment;
FIG. 7 is a brief top view of the hybrid bonding structure in FIG. 6 according to an exemplary embodiment;
FIG. 8 is a schematic view of a diffusion barrier layer in FIG. 4 according to an exemplary embodiment;
FIG. 9 is a schematic view of a diffusion barrier layer in FIG. 6 according to an exemplary embodiment;
FIG. 10 is another schematic view of a diffusion barrier layer according to an exemplary embodiment;
FIG. 11 is another schematic view of a diffusion barrier layer according to an exemplary embodiment;
FIG. 12 is a schematic view of a method for manufacturing a hybrid bonding structure according to an exemplary embodiment;
FIG. 13 is a schematic view of a first dielectric layer according to an exemplary embodiment;
FIG. 14 is a brief top view of FIG. 13 according to an exemplary embodiment;
FIG. 15 is a schematic view of a lower barrier layer and a lower metal structure according to an exemplary embodiment;
FIG. 16 is a schematic view of a bonding process of a first dielectric layer and a second dielectric layer according to an exemplary embodiment;
FIG. 17 is an initial schematic view of a hybrid bonding structure according to an exemplary embodiment;
FIG. 18 is a schematic view of a barrier trench according to an exemplary embodiment;
FIG. 19 is a brief top view of FIG. 18 according to an exemplary embodiment;
FIG. 20 is a schematic view of a diffusion barrier layer according to an exemplary embodiment; and
FIG. 21 is a schematic view of a semiconductor device according to an exemplary embodiment.

### DESCRIPTION OF EMBODIMENTS

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. The advantages and features of the present disclosure will become apparent from the following description and claims. It should be noted that the drawings are all in a very simplified form and not to a precise scale, and are provided only for the purpose of facilitating a convenient and clear description of the embodiments of the present disclosure.

It can be understood that the meaning of "on", "above", and "over" in the present disclosure should be interpreted in the broadest manner, such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and do not necessarily indicate a specific order or sequence.

In the embodiments of the present disclosure, the term "layer" refers to a material portion that includes a region having a thickness. A layer may extend over the entirety of an underlying or overlying structure or may have an extent that is less than an extent of the underlying or overlying structure. Furthermore, a layer may be a region of a homogeneous or inhomogeneous continuous structure having a thickness less than a thickness of a continuous structure. For example, a layer may be located between a top surface and a bottom surface of a continuous structure, or the layer may be located between any pair of horizontal planes at the top surface and the bottom surface of the continuous structure. A layer may extend horizontally, perpendicularly, and/or along an inclined surface. A layer may include a plurality of sub-layers.

It should be noted that the technical solutions described in the embodiments of the present disclosure may be combined arbitrarily without conflict.

Wafer bonding is the technology that, through atoms at a wafer interface under the action of external energy, wafers are bonded into a whole via Van der Waals forces, molecular forces, or even atomic forces. Hybrid bonding (for example, simultaneously including insulator-insulator bonding, semiconductor-semiconductor bonding, and metal-metal bonding) is a relatively common wafer bonding method, which is widely applied to the field of 3D chips, such as in a bonding process of a CMOS image sensor, a DRAM, a 3D-NAND flash memory, and a logic device.

However, the applicant has found that in the wafer bonding process, a thin layer of silicon oxide is formed at an interface between two wafers, and the silicon oxide fails to block the diffusion of metal atoms (copper atoms), further affecting the electromigration reliability of the bonding structure. Meanwhile, if a high voltage is applied to the bonding structure, the presence of diffused metal atoms may cause the bonding structure to short-circuit, posing a greater risk to the hybrid bonding structure.

In order to solve the above technical problems, the embodiments of the present disclosure propose a hybrid bonding structure 100. The hybrid bonding structure 100 includes a first substrate 101 and a second substrate 102, and the second substrate 102 is located on the first substrate 101. A dielectric layer 103 is provided between the first substrate 101 and the second substrate 102. The dielectric layer 103 may include a first dielectric layer 104 and a second dielectric layer 105. The first dielectric layer 104 is located on the first substrate 101, and the second dielectric layer 105 is located on the second substrate 102. In an embodiment of the present disclosure, the first substrate 101 and the first dielectric layer 104 may belong to a first wafer, and the second substrate 102 and the second dielectric layer 105 may belong to a second wafer. The second wafer is bonded to the first wafer, that is, bonded to the first dielectric layer 104 via the second dielectric layer 105. In this embodiment, the materials of the first dielectric layer 104 and the second dielectric layer 105 may be silicon oxide, silicon nitride, silicon oxynitride dielectric layers, or the like. The first dielectric layer 104 and the second dielectric layer 105 may be formed by a thermal oxidation method or a deposition method. For example, the oxidizing atmosphere of the thermal oxidation method may be dry-oxygen oxidation, steam oxidation, or wet-oxygen oxidation; the deposition method may be physical vapor deposition, chemical vapor deposition, sputtering, or the like.

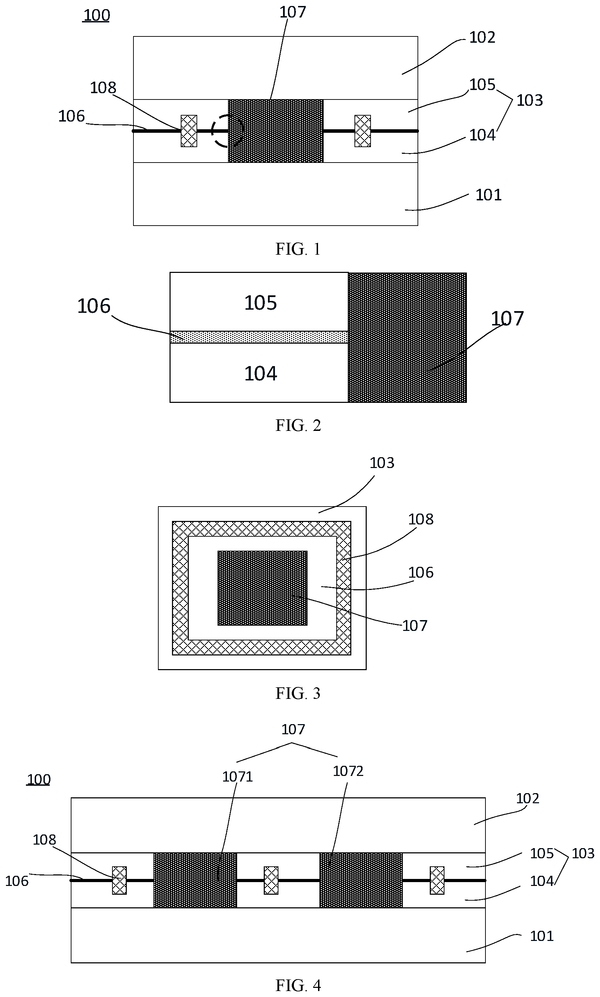

As shown in FIGS.1 to 2, FIG. 2 shows an enlarged view of a dashed box in FIG. 1. The dielectric layer 103 is formed when the first dielectric layer 104 is bonded to the second dielectric layer 105. Meanwhile, in the bonding process, a bonding interface layer 106 is formed between the first dielectric layer 104 and the second dielectric layer 105. The bonding interface layer 106 may also be a bonding combination layer. The principle of forming the bonding interface layer is as follows.

First, under the action of plasma, Si-OH bonds are formed on the surfaces of the first dielectric layer 104 and the second dielectric layer 105, respectively. The reaction manner may be Si-O-Si + H₂O = Si-OH + OH-Si.

Then, the Si-OH bonds on the first dielectric layer 104 and the second dielectric layer 105 are bonded, such that the first wafer is bonded to the second wafer. The reaction manner may be Si-OH + OH-Si = Si-O-Si + H₂O.

Therefore, the first dielectric layer 104 and the second dielectric layer 105 are bonded together by means of Si-OH generated by each of the first dielectric layer and the second dielectric layer, and meanwhile, a very thin bonding interface layer 106 is also formed between the first dielectric layer 104 and the second dielectric layer 105.

As shown in FIGS. 1 to 2, in the process of bonding the first dielectric layer 104 and the second dielectric layer 105, the metal in the first dielectric layer 104 is simultaneously bonded to the metal in the second dielectric layer 105, thereby forming a metal structure 107. That is, the metal structure 107 is located in the dielectric layer 103. In this embodiment, a material of the metal structure 107 may be copper. It should be noted that before the metal is formed in the first dielectric layer 104, it is necessary to first form a metal groove in the first dielectric layer 104, form a barrier layer in the metal groove, and then form a metal material on the barrier layer. The metal groove is filled with the metal material, thereby forming the metal. That is, due to the barrier layer, metal atoms in the first dielectric layer 104 do not diffuse. Similarly, metal atoms in the second dielectric layer 105 do not diffuse either. In the bonding process, due to the presence of the bonding interface layer 106, the metal structure 107 is in direct contact with the bonding interface layer 106. Since there is no barrier layer between the metal structure 107 and the bonding interface layer 106, copper atoms diffuse in the bonding interface layer 106 (silicon oxide), thereby reducing the electromigration reliability of the metal structure 107.

As shown in FIGS. 1 to 3, FIG. 3 shows a simple top view of a diffusion barrier layer 108 and a metal structure 107. The hybrid bonding structure 100 further includes a diffusion barrier layer 108. The diffusion barrier layer 108 is located in the dielectric layer 103 and also separates the bonding interface layer 106. It should be noted that the separation of the bonding interface layer 106 by the diffusion barrier layer 108 means that the entire bonding interface layer 106 is partitioned into several independent regions, thereby blocking copper atoms from further diffusing in the bonding interface layer 106. The bonding interface layer 106 is formed around the metal structure 107. Meanwhile, the diffusion barrier layer 108 also surrounds the metal structure 107. Therefore, when the copper atoms in the metal structure 107 diffuse into the surrounding bonding interface layer 106, the diffusion barrier layer 108 can achieve a blocking effect, preventing the copper atoms from diffusing further, thereby improving the electromigration reliability. Meanwhile, copper contamination can also be improved. In this embodiment, a thickness of the diffusion barrier layer 108 may be greater than a thickness of the bonding interface layer 106, improving the blocking capability of the diffusion barrier layer 108, and further reducing the diffusion of copper atoms in a deeper direction.

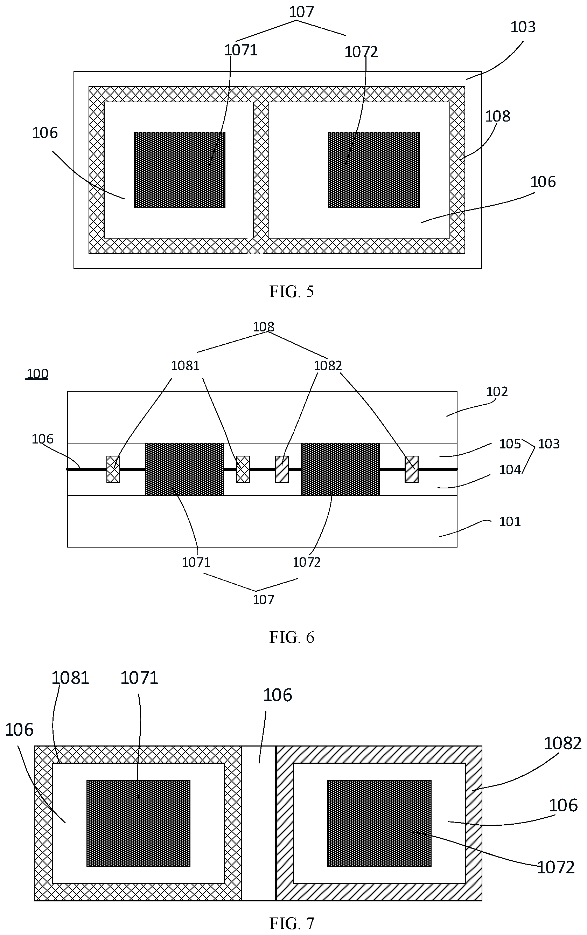

As shown in FIGS. 4 to 5, FIG. 4 shows two metal structures 107, i.e., a first metal structure 1071 and a second metal structure 1072. The structures of the first metal structure 1071 and the second metal structure 1072 are the same. FIG. 5 shows a brief top view of FIG. 4. The diffusion barrier layer 108 surrounds both the first metal structure 1071 and the second metal structure 1072; that is, the first metal structure 1071 and the second metal structure 1072 share a portion of the diffusion barrier layer 108. As can be seen from FIG. 5, the same diffusion barrier layer 108 is provided between the first metal structure 1071 and the second metal 1072, and a distance from the diffusion barrier layer 108 to the first metal structure 1071 is different from a distance from the diffusion barrier layer 108 to the second metal structure 1072. The diffusion barrier layer 108 may be made of a metal barrier material or an insulating barrier material. If a metal barrier material is used, since the distances from the diffusion barrier layer 108 to the two metal structures 107 are different, diffusion distances of copper atoms in the bonding interface layer 106 are different, which can prevent the copper atoms of the two metal structures from combining in the diffusion barrier layer 108, thereby preventing a short circuit between the two metal structures at a high voltage. Certainly, if the diffusion barrier layer 108 is made of an insulating barrier material, the distances from the diffusion barrier layer 108 to the two metal structures 107 may be the same. Certainly, the hybrid structure 100 may further include more metal structures 107. In this case, two adjacent metal structures 107 share a diffusion barrier layer 108, which may also be understood as all of the metal structures 107 sharing the same diffusion barrier layer 108.

As shown in FIGS. 6 to 7, FIG. 6 shows another structure of a hybrid structure, and FIG. 7 shows a brief top view of FIG. 6. The hybrid bonding structure 100 includes a plurality of diffusion barrier layers 108; that is, a first diffusion barrier layer 1081 and a second diffusion barrier layer 1082 are shown. The first diffusion barrier layer 1081 surrounds the first metal structure 1071, and the second diffusion barrier layer 1082 surrounds the second metal structure 1072. The first diffusion barrier layer 1081 and the second diffusion barrier layer 1082 are independent of each other; that is, there is no shared portion between the first diffusion barrier layer 1081 and the second diffusion barrier layer 1082. A portion of the bonding interface layer 106 is provided between the first diffusion barrier layer 1081 and the second diffusion barrier layer 1082. As can be seen from FIG. 6, a distance from the first diffusion barrier layer 1081 to the second diffusion barrier layer 1082 is greater than a distance from the first diffusion barrier layer 1081 to the first metal structure 1071 and is also greater than a distance from the second diffusion barrier layer 1082 to the second metal structure 1072. In this embodiment, the first diffusion barrier layer 1081 is closer to the first metal structure 1071, and the second diffusion barrier layer 1082 is closer to the second metal structure 1072. That is, the first diffusion barrier layer 1081 surrounds only the first metal structure 1071, and the second diffusion barrier layer 1082 surrounds only the second metal structure 1072, such that the diffusion distance of copper atoms is very short, which prevents the copper atoms from combining, and thereby can prevent a short circuit between the two metal structures 107 at a high voltage. In this embodiment, when the hybrid structure 100 includes more metal structures 107, the hybrid structure 100 also includes more diffusion barrier layers 108. The number of the diffusion barrier layers 108 may be equal to the number of the metal structures 107. Each of the diffusion barrier layers 108 surrounds each of the metal structures 107, and these diffusion barrier layers 108 are independent of each other. In some embodiments, the structures of the first diffusion barrier layer 1081 and the second diffusion barrier layer 1082 may be the same. For example, the first diffusion barrier layer and the second diffusion barrier layer are both metal barrier layers, insulating barrier layers, or a combination of a metal barrier layer and an insulating barrier layer.

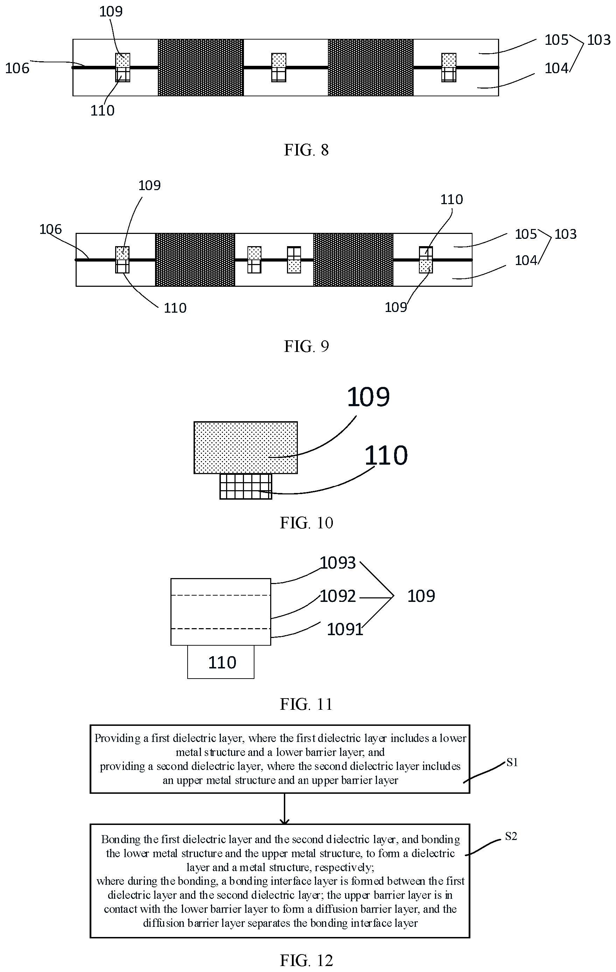

As shown in FIG. 8, FIG. 8 shows a structural view of the diffusion barrier layer 108 in FIG. 4. The diffusion barrier layer 108 includes an upper barrier layer 109 and a lower barrier layer 110. The upper barrier layer 109 is located in the second dielectric layer 105, and the lower barrier layer 110 is located in the first dielectric layer 104. When the second dielectric layer 105 is bonded to the first dielectric layer 104, the upper barrier layer 109 is located on the lower barrier layer 110. The upper barrier layer 109 is in close contact with the lower barrier layer 110, but the upper barrier layer 109 and the lower barrier layer 110 do not undergo a bonding reaction. In an embodiment of the present disclosure, the upper barrier layer 109 may be made of an insulating barrier material, such as silicon nitride or silicon carbonitride. The upper barrier layer 109 may also be made of a metal barrier material, such as tantalum or tantalum nitride. The lower barrier layer 110 may be made of an insulating material, such as silicon nitride, silicon carbonitride, or other materials. The lower barrier layer 110 may also be made of a metal barrier material, such as tantalum, tantalum nitride, or other materials. However, when an insulating barrier material is selected for the upper barrier layer 109, a metal barrier material may be selected for the lower barrier layer 110, and an insulating barrier material cannot be selected for the lower barrier layer 110. The reason is that if both the upper barrier layer 109 and the lower barrier layer 110 are made of insulating barrier materials, a bonding interface layer 106 is formed between the upper barrier layer 109 and the lower barrier layer 110. That is, the formed diffusion barrier layer 108 does not separate the bonding interface layer 106; that is, the diffusion barrier layer can not function to block the diffusion of copper atoms. Certainly, when a metal barrier material is selected for the upper barrier layer 109, an insulating barrier material may be selected for the lower barrier layer 110. That is, one of the insulating barrier material and the metal barrier material may be selected for the upper barrier layer 109, and the other of the insulating barrier material and the metal barrier material may be selected for the lower barrier layer 110.

As shown in FIG. 8, in this embodiment, the upper barrier layer 109 is located right above the lower barrier layer 110. In a horizontal direction, a width of the upper barrier layer 109 is equal to a width of the lower barrier layer 110. A projection region of the upper barrier layer 109 in the first dielectric layer 104 may cover a projection region of the lower barrier layer 110 in the first dielectric layer 104; that is, a projected area of the upper barrier layer 109 in the first dielectric layer 104 may be greater than a projected area of the lower barrier layer 110 in the first dielectric layer 104. In this embodiment, in FIG. 8, the projected area of the upper barrier layer 109 in the first dielectric layer 104 may completely coincide with the projected area of the lower barrier layer 110 in the first dielectric layer 104, thereby ensuring that the upper barrier layer 109 is in full contact with the lower barrier layer 110, and improving the capability of blocking the diffusion of copper atoms. In this embodiment, thicknesses of the upper barrier layer 109 and the lower barrier layer 110 are consistent. The upper barrier layer 109 is made of, for example, an insulating barrier material, such as silicon nitride. The lower barrier layer 110 is made of, for example, a metal barrier material, such as tantalum.

As shown in FIG. 9, FIG. 9 shows a brief schematic view of the diffusion barrier layer in FIG. 6. The structures of the first diffusion barrier layer 1081 in FIG. 9 and the diffusion barrier layer 108 in FIG. 8 are the same. The first diffusion barrier layer 1081 also includes an upper barrier layer 109 and a lower barrier layer 110. The upper barrier layer 109 is located on the lower barrier layer 110. The second diffusion barrier layer 1082 in FIG. 9 also includes an upper barrier layer 109 and a lower barrier layer 110. The lower barrier layer 110 is located on the upper barrier layer 109. The structure of the second diffusion barrier layer 1082 is opposite to the structure of the first diffusion barrier layer 1081. That is, the upper barrier layer 109 in the first diffusion barrier layer 1081 is located in the second dielectric layer 105, and the lower barrier layer 110 is located in the first dielectric layer 104; the upper barrier layer 109 in the second diffusion barrier layer 1082 is located in the first dielectric layer 104, and the lower barrier layer 110 is located in the second dielectric layer 105. In this embodiment, since the upper barrier layers 109 are made of an insulating barrier material, and the lower barrier layers 110 are made of a metal barrier material, the lower barrier layers 110 are located in different dielectric layers, avoiding a short circuit between the lower barrier layers 110. As can be seen from FIG. 9, the thickness of the upper barrier layer 109 and the thickness of the lower barrier layer 110 may be substantially consistent.

As shown in FIG. 10, in some embodiments, in the horizontal direction, the width of the upper barrier layer 109 is different from the width of the lower barrier layer 110. For example, the width of the upper barrier layer 109 is greater than the width of the lower barrier layer 110. That is, a projected area of the upper barrier layer 109 on the dielectric layer is greater than a projected area of the lower barrier layer 110 on the dielectric layer; that is, the upper barrier layer 109 can completely cover the lower barrier layer 110. In this embodiment, since the upper barrier layer 109 is made of an insulating barrier material, and the lower barrier layer 110 is made of a metal barrier material, the width of the upper barrier layer 109 is increased without causing the problem of short circuit. Certainly, if the upper barrier layer 109 is made of a metal barrier material, and the lower barrier layer 110 is made of an insulating barrier material, the width of the lower barrier layer 110 may be greater than the width of the upper barrier layer 109.

As shown in FIGS. 10 to 11, in some embodiments, the thickness of the upper barrier layer 109 may also be greater than the thickness of the lower barrier layer 110. Since the upper barrier layer 109 is made of an insulating barrier material, and the lower barrier layer 110 is made of a metal barrier material, when the thickness of the upper barrier layer 109 is larger, a top of the upper barrier layer 109 may be doped with more nitrogen elements, such that the top of the upper barrier layer 109 has a higher nitrogen concentration, and a bottom of the upper barrier layer 109 has a lower nitrogen concentration. The higher the nitrogen concentration is, the higher the density of the insulating barrier material is, thereby further improving the blocking capability of the top of the upper barrier layer 109. It should be noted that a surface where the upper barrier layer 109 is in contact with the lower barrier layer 110 is a top surface of the upper barrier layer 109; therefore, the portion, close to the lower barrier layer 110, of the upper barrier layer 109 is the top of the upper barrier layer 109. The upper barrier layer 109 may include a barrier top part 1091, a barrier middle part 1092, and a barrier bottom part 1093. In the present application, a face-to-face hybrid bonding method is used, such that the barrier top part 1091 is closer to the lower barrier layer 110. By increasing the thickness of the upper barrier layer 109, nitrogen doping is better performed on the barrier top part 1091, and the nitrogen concentration is improved, such that copper atoms are diffused on a contact surface between the upper barrier layer 109 and the lower barrier layer 110. Certainly, in some embodiments, a back-to-back hybrid bonding method or a face-to-back hybrid bonding method may also be used.

As shown in FIG. 12, the embodiments of the present disclosure further propose a method for manufacturing a hybrid bonding structure. The method includes the steps as follows.

In S1, a first dielectric layer is provided, where the first dielectric layer includes a lower metal structure and a lower barrier layer; and a second dielectric layer is provided, where the second dielectric layer includes an upper metal structure and an upper barrier layer.

In S2, the first dielectric layer and the second dielectric layer are bonded, and the lower metal structure and the upper metal structure are bonded, to form a dielectric layer and a metal structure, respectively, where during the bonding, a bonding interface layer is formed between the first dielectric layer and the second dielectric layer; the upper barrier layer is in contact with the lower barrier layer to form a diffusion barrier layer, and the diffusion barrier layer separates the bonding interface layer.

As shown in FIGS. 12 to 15, in step S1, an example in which the lower barrier layer is formed is used for illustration in this embodiment. First, a first wafer is provided. The first wafer includes a first substrate 101, and a first dielectric layer 104 is provided on the first substrate 101. Then, the first dielectric layer 104 is etched to form a lower metal groove 111 and a lower barrier trench 112. The lower barrier trench 112 surrounds the lower metal groove 111. Then, a metal material is filled into the lower metal groove 111 to form a lower metal structure 113; a barrier material is filled into the lower barrier trench 112 to form a lower barrier layer 110, such that the lower barrier layer 110 can surround the lower metal structure 113. Certainly, in some embodiments, it is also possible to first form the lower metal structure 113, and then etch the first dielectric layer 104 to form the lower barrier trench 112; the lower barrier trench 112 is then filled, thereby forming the lower barrier layer 110. That is, the lower barrier layer 110 and the lower metal structure 113 may be simultaneously formed, and the lower barrier layer 110 may also be formed after the lower metal structure 113. Certainly, in some embodiments, the lower barrier layer 110 may also be formed before the lower metal structure. For example, the lower barrier layer 110 is formed first, and then the lower metal groove 111 is formed and filled with a metal material to form the lower metal structure 113.

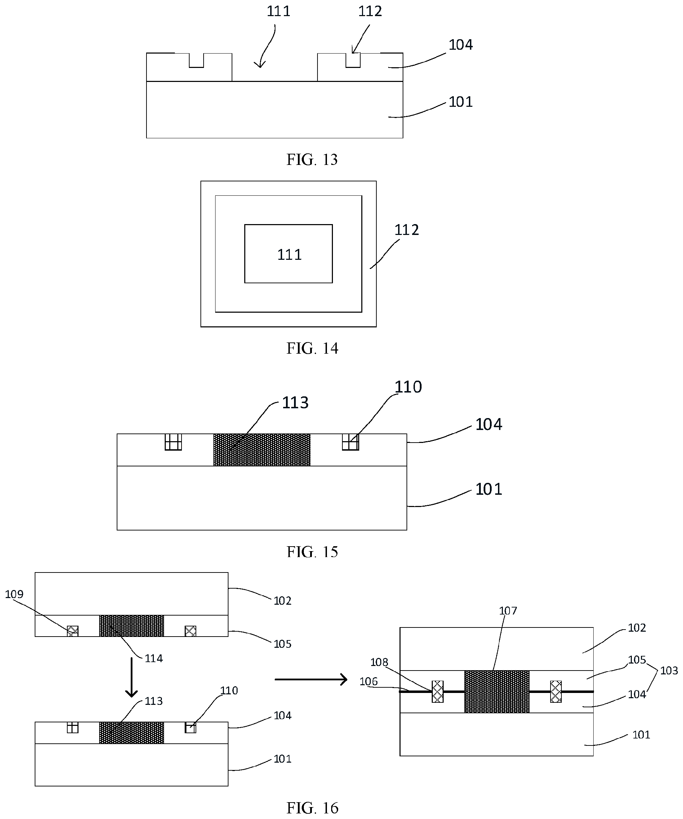

As shown in FIGS. 14 to 15, a material of the lower barrier layer 110 may be a metal barrier material, such as tantalum, tantalum nitride, titanium, titanium nitride, or other materials. A material of the lower metal structure 113 may be copper. It should be noted that before the lower metal structure 113 is formed, a metal barrier material also needs to be formed on an inner wall of the lower metal groove 111, thereby preventing copper atoms from diffusing into the first dielectric layer 104. Therefore, in this embodiment, while the metal barrier material is formed in the lower metal groove 111, the metal barrier material may also be formed in the lower barrier trench 112, thereby forming the lower barrier layer 110 simultaneously.

For a process of forming the upper barrier layer 109, reference may be made to the process of forming the lower barrier layer 110. Meanwhile, since the upper barrier layer 109 is made of an insulating barrier material, the thickness of the upper barrier layer 109 may be appropriately increased, and the nitrogen concentration at the top of the upper barrier layer 109 may be improved. For example, when forming the top of the upper barrier layer 109, the nitrogen plasma concentration is improved, thereby improving the nitrogen concentration at the top of the upper barrier layer 109, improving the density at the top of the upper barrier layer 109, and improving the blocking capability.

As shown in FIG. 16, in step S2, the second wafer is bonded to the first wafer; that is, a front surface of the second wafer is bonded to a front surface of the first wafer. The first wafer includes a first substrate 101, and a first dielectric layer 104 is provided on the first substrate 101. The first dielectric layer 104 includes a lower metal structure 113 and a lower barrier layer 110, and the lower barrier layer 110 surrounds the lower metal structure 113. The second wafer includes a second substrate 102, and a second dielectric layer 105 is provided on the second substrate 102. The second dielectric layer 105 includes an upper metal structure 114 and an upper barrier layer 109, and the upper barrier layer 109 surrounds the upper metal structure 114. In this embodiment, a surface, facing the first dielectric layer 104, of the second dielectric layer 105 may be a front surface of the second wafer; therefore, a surface, facing the lower barrier layer 110, of the upper barrier layer 109 may be a top surface of the upper barrier layer 109. In the bonding process, the first dielectric layer 104 and the second dielectric layer 105 undergo a bonding reaction, and the lower metal structure 113 and the upper metal structure 114 undergo a bonding reaction, thereby forming a dielectric layer 103 and a metal structure 107. Meanwhile, in the process of bonding the first dielectric layer 104 and the second dielectric layer 105, a bonding interface layer 106 is formed between the first dielectric layer 104 and the second dielectric layer 105; that is, the bonding interface layer 106 is located in the dielectric layer 103. The bonding interface layer 106 surrounds the metal structure 107. However, since the upper barrier layer 109 does not undergo a bonding reaction with the lower barrier layer 110, the upper barrier layer 109 and the lower barrier layer 110 are in close contact, and the diffusion barrier layer 108 is formed. Since a bonding interface layer 106 will not be formed between the upper barrier layer 109 and the lower barrier layer 110, the diffusion barrier layer 108 functions to separate the bonding interface layer 106. Since the diffusion barrier layer 108 separates the bonding interface layer 106, even if copper atoms in the metal structure 107 can diffuse in the bonding interface layer 106, the copper atoms do not diffuse deeper into the bonding interface layer 106, thereby improving the electromigration reliability of the metal structure 107, and reducing the risk posed by the diffusion of copper atoms.

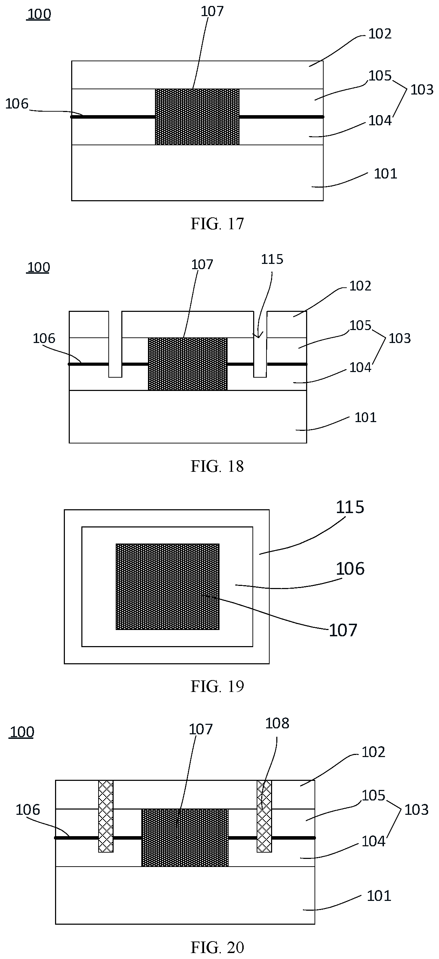

As shown in FIG. 17, the embodiments of the present disclosure further propose a method for manufacturing a hybrid bonding structure. First, a second wafer is bonded to a first wafer. The first wafer includes a first substrate 101 and a first dielectric layer 104. The first dielectric layer 104 includes a lower metal structure. The second wafer includes a second substrate 102 and a second dielectric layer 105. The second dielectric layer 105 includes an upper metal structure. In the bonding process, the first dielectric layer 104 and the second dielectric layer 105 are bonded to form a dielectric layer 103. The upper metal structure and the lower metal structure are bonded to form a metal structure 107. Meanwhile, a bonding interface layer 106 is also formed between the first dielectric layer 104 and the second dielectric layer 105. The bonding interface layer 106 may be in contact with the metal structure 107. After the bonding process is completed, a back surface of the second substrate 102 is thinned, such that the thickness of the second substrate 102 is less than the thickness of the first substrate 101.

As shown in FIGS. 18 to 19, since the second substrate 102 has been thinned, the thickness of the second substrate 102 is reduced, thereby facilitating the formation of a barrier trench 115. In this embodiment, the second substrate 102, the second dielectric layer 105, the bonding interface layer 106, and the first dielectric layer 104 may be etched by using an etching process, thereby forming the barrier trench 115. That is, the barrier trench 115 extends from the second substrate 102 into the first dielectric layer 104. As a result, the barrier trench 115 destroys the integrity of the bonding interface layer 106; that is, the barrier trench 115 separates the bonding interface layer 106. As can be seen from FIG. 19, the barrier trench 115 surrounds the metal structure 107.

As shown in FIG. 20, after the barrier trench 115 is formed, an insulating barrier material is filled into the barrier trench 115, thereby forming a diffusion barrier layer 108. A surface of the diffusion barrier layer 108 is flush with a surface of the second substrate 102, and the diffusion barrier layer 108 extends from the second substrate 102 into the first substrate 101, such that the diffusion barrier layer 108 can separate the bonding interface layer 106. Since the diffusion barrier layer 108 surrounds the metal structure 107, and the diffusion barrier layer 108 separates the bonding interface layer 106, the diffusion barrier layer 108 can block metal atoms from extending in a deeper direction in the bonding interface layer 106, thereby improving the electromigration reliability of the metal structure 107.

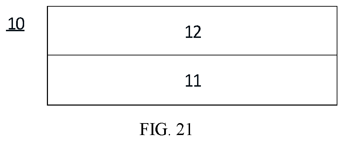

As shown in FIG. 21, the embodiments of the present disclosure further propose a semiconductor device 10. The semiconductor device 10 may include a first semiconductor structure 11 and a second semiconductor structure 12. The first semiconductor structure 11 may be bonded to the second semiconductor structure 12. The first semiconductor structure 11 and the second semiconductor structure 12 may be fixed together by hybrid bonding, and the above hybrid bonding structure may also be formed between the first semiconductor structure 11 and the second semiconductor structure 12, thereby improving the performance of the semiconductor device. The semiconductor device 10 may be a multilayer stack structure, such as an HBM structure. The semiconductor device 10 may also be applied to an electronic apparatus. The electronic apparatus may include one or more of the following: for example, a smart phone, a tablet personal computer (PC), a mobile phone, a video phone, an electronic book (e-book) reader, a desktop PC, a laptop PC, a netbook computer, a workstation, a server, a personal digital assistant (PDA), a portable multimedia player (PMP), an MPEG-1 Audio Layer 3 (MP3) player, mobile medical equipment, a camera, a household appliance, medical equipment, an Internet of Things (IoT) apparatus, and a wearable apparatus. The wearable apparatus may be of an accessory type, a fabric or clothing type, a body attachment type, or an implantable circuit type. An accessory-type wearable apparatus may be, for example, a watch, a ring, a bracelet, an anklet, a necklace, glasses, contact lenses, or a head-mounted display (HMD).

In summary, the embodiments of the present disclosure propose a hybrid bonding structure, a manufacturing method therefor, and a semiconductor device. A diffusion barrier layer is formed in a dielectric layer, which blocks copper atoms from diffusing further into a bonding interface layer, thereby improving the electromigration reliability of a metal structure, while also reducing contamination caused by the diffusion of copper atoms.

The above description is only the specific embodiments of the present disclosure, but the protection scope of the present disclosure is not limited thereto. Changes or substitutions that anyone skilled in the art can easily think of within the technical scope disclosed by the present disclosure shall all fall within the protection scope of the present disclosure. Therefore, the protection scope of the present disclosure shall be defined by the protection scope of the claims.

## Claims

1. A hybrid bonding structure, comprising:
a dielectric layer, comprising a first dielectric layer and a second dielectric layer that are bonded;
a bonding interface layer, located between the first dielectric layer and the second dielectric layer;
a metal structure, located in the dielectric layer; and
a diffusion barrier layer (108), located in the dielectric layer, wherein the diffusion barrier layer separates the bonding interface layer.

2. The hybrid bonding structure according to claim 1, wherein the diffusion barrier layer surrounds the metal structure.

3. The hybrid bonding structure according to claim 1, wherein a thickness of the bonding interface layer is less than a thickness of the diffusion barrier layer.

4. The hybrid bonding structure according to claim 1, wherein the metal structure comprises a first metal structure and a second metal structure, the diffusion barrier layer is located between the first metal structure and the second metal structure, and a spacing from the diffusion barrier layer to the first metal structure is different from a spacing from the diffusion barrier layer to the second metal structure.

5. The hybrid bonding structure according to claim 4, wherein the diffusion barrier layer comprises a first diffusion barrier layer and a second diffusion barrier layer, the first diffusion barrier layer surrounding the first metal structure, and the second diffusion barrier layer surrounding the second metal structure,
wherein a spacing from the first diffusion barrier layer to the second diffusion barrier layer is greater than a spacing from the first diffusion barrier layer to the first metal structure.

6. The hybrid bonding structure according to claim 5, wherein the first diffusion barrier layer and the second diffusion barrier layer comprise:
a lower barrier layer, and
an upper barrier layer, located on the lower barrier layer,
wherein the upper barrier layer and the lower barrier layer do not undergo a bonding reaction.

7. The hybrid bonding structure according to claim 6, wherein an orthographic projection region of the lower barrier layer is located within an orthographic projection region of the upper barrier layer.

8. The hybrid bonding structure according to claim 6, wherein the lower barrier layer of the first diffusion barrier layer is located in the first dielectric layer, and the upper barrier layer of the first diffusion barrier layer is located in the second dielectric layer; the lower barrier layer of the second diffusion barrier layer is located in the second dielectric layer, and the upper barrier layer of the second diffusion barrier layer is located in the first dielectric layer.

9. The hybrid bonding structure according to claim 6, wherein the lower barrier layer comprises one of a metal barrier layer or an insulating barrier layer, and the upper barrier layer is the other of the metal barrier layer or the insulating barrier layer.

10. The hybrid bonding structure according to claim 6, wherein a thickness of the upper barrier layer is greater than a thickness of the lower barrier layer.

11. The hybrid bonding structure according to claim 6, wherein a top surface of the upper barrier layer is in contact with the lower barrier layer, and a nitrogen concentration at a bottom of the upper barrier layer is less than a nitrogen concentration at a top of the upper barrier layer.

12. The hybrid bonding structure according to claim 1 , wherein a plurality of the metal structures are provided, and the plurality of metal structures share a same diffusion barrier layer.

13. The hybrid bonding structure according to claim 1, wherein a plurality of the metal structures are provided, and a plurality of the diffusion barrier layers are provided, a number of the metal structures being equal to a number of the diffusion barrier layers.

14. The hybrid bonding structure according to claim 13, wherein each of the diffusion barrier layers surrounds each of the metal structures, and the plurality of diffusion barrier layers are independent of each other.

15. The hybrid bonding structure according to claim 9, wherein a material of the metal barrier layer comprises tantalum or tantalum nitride, and a material of the insulating barrier layer comprises silicon nitride or silicon carbonitride.

16. A method for manufacturing a hybrid bonding structure , comprising:
providing a first dielectric layer, wherein the first dielectric layer comprises a lower metal structure and a lower barrier layer ;
providing a second dielectric layer, wherein the second dielectric layer comprises an upper metal structure and an upper barrier layer; and
bonding the first dielectric layer and the second dielectric layer, and bonding the upper metal structure and the lower metal structure, to form a dielectric layer and a metal structure, respectively;
wherein during the bonding, a bonding interface layer is formed between the first dielectric layer and the second dielectric layer; the upper barrier layer is in contact with the lower barrier layer to form a diffusion barrier layer , and the diffusion barrier layer separates the bonding interface layer.

17. The method according to claim 16, wherein during the bonding, the upper barrier layer and the lower barrier layer do not undergo a bonding reaction.

18. The method according to claim 16, wherein a step of forming the lower barrier layer comprises:
forming, in the first dielectric layer, a trench surrounding the lower metal structure; and
filling the trench with a diffusion barrier material to form the lower barrier layer.

19. The method according to claim 16, wherein a step of forming the upper barrier layer comprises:
forming, in the second dielectric layer, a trench surrounding the upper metal structure; and
filling the trench with a diffusion barrier material to form the upper barrier layer;
wherein a nitrogen concentration at a top of the upper barrier layer is greater than a nitrogen concentration at a bottom of the upper barrier layer.

20. A semiconductor device (10), comprising the hybrid bonding structure (100) according to any one of claims 1 to 15.
